# EUROPÄISCHE PATENTSCHRIFT

(11) **EP 3 341 980 B1**
(45) Veröffentlichungstag und Bekanntmachung des Hinweises auf die Patenterteilung: **20.07.2022**
(21) Anmeldenummer: 16765934.1
(22) Anmeldetag: 26.08.2016
(51) Int. Cl.: H01L 41/314

(54) **SCHICHT UND VERFAHREN ZU IHRER HERSTELLUNG**
LAYER AND METHOD FOR THE PRODUCTION THEREOF
COUCHE ET PROCÉDÉ POUR LA FORMER

(30) Priorität: 26.08.2015 DE 102015216312; 04.11.2015 DE 102015221576; 05.01.2016 DE 102016200038
(43) Veröffentlichungstag der Anmeldung: 04.07.2018
(73) Patentinhaber: CeramTec GmbH, 73207 Plochingen (DE)
(72) Erfinder: SCHREINER, Hans-Jürgen, 91217 Hersbruck (DE); EINHELLINGER-MÜLLER, Tanja, 90461 Nürnberg (DE); SCHMIDT, Tobias, 91207 Lauf (DE); MOOS, Ralf, 95447 Bayreuth (DE); SCHUBERT, Michael, 95448 Bayreuth (DE)
(86) Internationale Anmeldenummer: PCT/EP2016/070162
(87) Internationale Veröffentlichungsnummer: WO 2017/036945

(56) Entgegenhaltungen:
- JP-A- 2010 189 741
- US-A1- 2007 138 906
- US-B1- 6 347 441

## Beschreibung

Die vorliegende Erfindung betrifft ein Verfahren zur Herstellung einer Schicht mit piezoelektrischen Eigenschaften, über ein Aerosolabscheideverfahren (ADM-Prozess (Aerosol Deposition Method)), gemäss Anspruch 1. Zur Herstellung von Schichten mit piezoelektrischen Eigenschaften sind bisher nur Verfahren bekannt, die eine Temperaturbehandlung (Sintern/Tempern) bei Temperaturen > 500°C umfassen. Beim Auftreffen auf das Substrat werden die Partikel in kleinere Subpartikel zerlegt. Bisher war es jedoch notwendig, nach diesem Zerlegen in Subpartikel einen Temperschritt > 500°C durchzuführen, um einen piezoelektrischen Effekt bzw. eine piezoelektrische Eigenschaft der Schicht zu erzeugen.

Der vorliegenden Erfindung lag deshalb die Aufgabe zugrunde, eine Schicht mit piezoelektrischen Eigenschaften sowie ein Verfahren zur Herstellung von Schichten mit piezoelektrischen Eigenschaften bereitzustellen, die die vorgenannten Probleme nicht aufweist und insbesondere den Temperschritt >500°C wegzulassen.

Kann die Aufbringung der Schicht und/oder die Temperung bei Temperaturen <500°C, bevorzugt <350°C und besonders bevorzugt <300°C erfolgen, gibt es deutlich mehr Anwendungsmöglichkeiten und deutlich mehr Substrate, die eingesetzt werden können.

Die Aufgabe wird durch die Bereitstellung einer Schicht mit piezoelektrischen Eigenschaften gelöst, wobei während und nach der Beschichtung keine Temperaturbehandlung > 500 °C erfolgt. Die piezoelektrischen Eigenschaften der Schicht werden bei Raumtemperatur oder durch eine Temperung bei Temperaturen bis max. 350°C ausgebildet. Dabei wird das Pulver (für die Schicht) und/oder das Substrat bzw. der Träger während der Beschichtung nicht mittels einer externen Wärmequelle auf Temperaturen über 350°C erhitzt werden. Insbesondere bevorzugt sind nachfolgende Temperaturbehandlungen bei Temperaturen <300°C.

Die Beschichtung wird dabei über ein Aerosolabscheideverfahren der pulverförmigen Rohstoffe mittels eines Gasstromes (Trägergase können Luft, Edelgase, Sauerstoff, Stickstoff Wasserstoff oder Gemische daraus sein, besonders bevorzugt ist Luft) auf ein geeignetes Substrat bzw. einen geeigneten Träger aufgebracht. Das Substrat oder der Träger, auf den die Schicht aufgebracht wird, besteht bevorzugt aus Keramik, Kunststoff, Glas, Metall, Halbleiter oder einem Komposit aus den genannten Materialien.

Dabei weist das Substrat bzw. der Träger vorzugsweise eine geringere Härte als das Bulkmaterial der pulverförmigen Rohstoffe, die zur Aerosolabscheidung verwendet werden, auf. Die Schicht kann vorzugsweise unabhängig von der Form oder Ausgestaltung des Substrats bzw. des Trägers aufgebracht werden. Das Substrat bzw. der Träger kann eine beliebige Form, z.B. Krümmungen, aufweisen.

Die Schicht mit piezoelektrischen Eigenschaften der vorliegenden Erfindung ist vorzugsweise eine keramische Schicht, besonders bevorzugt besteht die Schicht aus PZT oder PZT-beinhaltendem Material oder bleifreier Piezokeramik. Die Dicke der Schicht liegt vorzugsweise im Bereich < 100 µm. Die Korngrößen in der Schicht liegen vorzugsweise im Bereich < 1µm, wobei die Korngröße optisch oder mittels Elektronenmikroskopie bestimmt wird. Außerdem weist die Schicht vorzugsweise eine poröse bis dichte Struktur auf, bevorzugt >95% der theoretischen Dichte.

Die Haftung und eine ausreichende Haftfestigkeit zwischen Schicht und Substrat bzw. Träger erfolgt bevorzugt durch eine mikrostrukturelle plastische Deformation der Oberfläche des Substrats bzw. des Trägers, eine sogenannte mechanische Verankerung.

Die aufgetragene Schicht bedeckt das Substrat bzw. den Träger nach dem Beschichtungsverfahren vorzugsweise ganz oder partiell. Weiterhin kann das Substrat oder der Träger eine Zwischenschicht aufweisen, auf der die Abscheidung ganz oder partiell erfolgt.

In einer bevorzugten Ausführungsform sind unter und/oder über der Schicht Elektroden vollflächig oder partiell angeordnet, die den piezoelektrischen Betrieb der Schicht erlauben. Beispielsweise können die Elektroden unter und/oder über der Schicht in einer Interdigitalstruktur angeordnet sein.

Zudem kann die Schicht strukturiert oder polarisiert werden. Vorzugsweise wird die Schicht bei der Abscheidung oder anschließend strukturiert oder bei der Abscheidung oder anschließend polarisiert. Ein Beispiel aus dem Stand der Technik findet sich in Patentdokument US2007/0138906.

### Ausführungsbeispiel: PZT auf Edelstahl

Aerosolabscheidung:
Aus PZT-Pulver und einem Trägergas wird in einem Aerosolgenerator ein Aerosol erzeugt. Das Aerosol wird in einer Abscheidekammer, in welcher mit Hilfe einer Vakuumpumpe Unterdruck erzeugt wird, mittels einer (schlitzförmigen) Düse auf das zu beschichtende Edelstahlsubstrat aufgesprüht. Aufgrund des Druckunterschieds zwischen Aerosolflasche und Abscheidekammer wird das Aerosol beschleunigt und trifft mit hohen Geschwindigkeiten auf das Edelstahlsubstrat auf. Die PZT-Partikel zerbrechen beim Aufprall, bleiben auf dem Substrat haften und bilden dort, eine Schicht aus. Durch die Beweglichkeit des Edelstahlsubstrats, das sich im Gegensatz zur fest positionierten Düse auf einem fahrbaren Tisch befindet, kann eine (groß)flächige Beschichtung erfolgen.

### Tempern

Ein Teil der PZT-beschichteten Proben wird im Ofen bei 300°C für ca. 2h getempert

### Metallisieren

Für den Polarisationsprozess kann das Edelstahlsubtrat als Elektrode verwendet werden. Die Gegenelektrode wird durch Aufsputtern einer Metallschicht auf die PZT-Schicht erzeugt. Dabei muss darauf geachtet werden, dass ein isolierender PZT-Rand zwischen Edelstahlsubstrat und Sputterschicht erhalten bleibt. Dies kann durch die Verwendung einer entsprechenden Maske gewährleistet werden.

### Polarisieren

Eine ca. 30µm dicke PZT-Schicht wird durch ein trapezförmiges Spannungssignal polarisiert.

### Messergebnisse

An den polarisierten Schichten wurde mittels eines Berlincourt-Meters der d33-Wert bestimmt. Die Minima und Maxima der an mehreren Stellen der Probenfläche ermittelten d33-Messwerte sind in Tabelle 1 aufgelistet.

**Tabelle 1: d33-Messwerte (Tag 1 nach Polarisation), RT: Raumtemperatur (keine Temperung).**

| Nr | Material | Schichtdicke [µm] | Tempertemperatur [°C] | d33 min [pC/N] | d33 max [pC/N] |
|---|---|---|---|---|---|
| 6 | FeNi | 28 | 300 | 26 | 38 |
| 8 | FeNi | 26 | RT | 10 | 17 |
| 9 | FeNi | 24 | RT | 5 | 14 |
| 10 | FeNi | 23 | 300 | 61 | 78 |
| 14 | FeNi | 18 | 300 | 37 | 43 |

Die piezoelektrischen Daten zeigen, dass es trotz der geringen Temperaturen gelingt, einen nutzbaren piezoelektrischen Effekt unter den oben genannten Abscheidebedingungen zu erzielen.

## Patentansprüche

1. Verfahren zur Herstellung einer Schicht mit piezoelektrischen Eigenschaften, wobei pulverförmige Rohstoffe mittels Gasstrom über ein Aerosolabscheideverfahren auf ein Substrat bzw. einen Träger aufgebracht werden, und **dadurch gekennzeichnet, dass** die piezoelektrischen Eigenschaften der Schicht bei Raumtemperatur oder durch Tempern bei Temperaturen bis max. 350°C ausgebildet werden, wobei während der Beschichtung keine Temperaturbehandlung der pulverförmigen Rohstoffe und/oder des Substrats bzw. des Trägers mittels einer externen Wärmequelle mit Temperaturen über 350 °C erfolgt.

2. Verfahren nach Anspruch 1, **dadurch gekennzeichnet, dass** die Schicht aus PZT oder PZT-beinhaltendem Material oder bleifreier Piezokeramik besteht.

3. Verfahren nach einem der vorhergehenden Ansprüche, **dadurch gekennzeichnet, dass** das Substrat bzw. der Träger aus Keramik, Kunststoff, Glas, Metall, Halbleiter oder einem Komposit aus den genannten Materialien besteht.

4. Verfahren nach Anspruch 3, **dadurch gekennzeichnet, dass** das Substrat bzw. der Träger eine geringere Härte als das Bulkmaterial der pulverförmigen Rohstoffe, die zur Aerosolabscheidung verwendet werden, aufweist.

5. Verfahren nach einem der vorhergehenden Ansprüche, **dadurch gekennzeichnet, dass** die Haftfestigkeit zwischen Schicht und Substrat bzw. Träger u.a. durch eine mikrostrukturelle plastische Deformation der Oberfläche des Substarts bzw. des Trägers (mechanische Verankerung) zustande kommt.

6. Verfahren nach einem der vorhergehenden Ansprüche, **dadurch gekennzeichnet, dass** die Schicht eine Dicke von < 100 µm aufweist, eine poröse bis dichte Struktur aufweist und die Korngrößen in der Schicht unter 1µm liegen.

7. Verfahren nach einem der vorhergehenden Ansprüche, **dadurch gekennzeichnet, dass** die Schicht das Substrat bzw. den Träger nach dem Beschichtungsverfahren ganz oder partiell bedeckt.

8. Verfahren nach einem der vorhergehenden Ansprüche, **dadurch gekennzeichnet, dass** der Träger mit einer Zwischenschicht versehen ist, auf der die Abscheidung ganz oder partiell erfolgt.

9. Verfahren nach einem der vorhergehenden Ansprüche, **dadurch gekennzeichnet, dass** unter oder über der Schicht Elektroden vollflächig oder partiell angeordnet sind, die den Betrieb erlauben.

10. Verfahren nach Anspruch 9, **dadurch gekennzeichnet, dass** unter und, oder über der Schicht Elektroden in einer Interdigitalstruktur angeordnet sind, die den Betrieb erlauben.

11. Verfahren nach einem der vorhergehenden Ansprüche, **dadurch gekennzeichnet, dass** das Substrat bzw. der Träger eine beliebige Form, z.B. Krümmungen, aufweist.

12. Verfahren nach einem der vorhergehenden Ansprüche, **dadurch gekennzeichnet, dass** die Schicht bei der Abscheidung oder anschließend strukturiert wird.

13. Verfahren nach einem der vorhergehenden Ansprüche, **dadurch gekennzeichnet, dass** die Schicht bei der Abscheidung oder anschließend polarisiert wird.

## Claims

1. Method for producing a layer having piezoelectric properties, the powdered raw materials being deposited on a substrate or a carrier by means of a gas stream using an aerosol deposition process, **characterized in that** the piezoelectric properties of the layer are formed at room temperature or by annealing at temperatures up to a maximum of 350°C, the powder and/or the substrate or the carrier not being heat-treated by means of an external heat source at temperatures above 350°C during the coating.

2. Method according to claim 1, **characterized in that** the layer is made of PZT or PZT-containing material or lead-free piezoceramics.

3. Method according to either of the preceding claims, **characterized in that** the substrate or the carrier is made of ceramic, plastics material, glass, metal, semiconductor or a composite of the aforementioned materials.

4. Method according to claim 3, **characterized in that** the substrate or the carrier has a lower hardness than the bulk material of the powdered raw materials which are used for the aerosol deposition.

5. Method according to any of the preceding claims, **characterized in that** the bonding strength between the layer and the substrate or carrier is achieved, inter alia, by microstructural plastic deformation of the surface of the substrate or the carrier (mechanical anchoring).

6. Method according to any of the preceding claims, **characterized in that** the layer has a thickness of < 100 µm and a porous to dense structure, and the particle sizes in the layer are less than 1 µm.

7. Method according to any of the preceding claims, **characterized in that** the layer completely or partially covers the substrate or the carrier after the coating process.

8. Method according to any of the preceding claims, **characterized in that** the carrier is provided with an intermediate layer on which full or partial deposition takes place.

9. Method according to any of the preceding claims, **characterized in that** electrodes which provide for the operation are arranged below or above the layer over its entire surface or over part thereof.

10. Method according to claim 9, **characterized in that** electrodes which provide for the operation are arranged below and/or above the layer in an interdigital structure.

11. Method according to any of the preceding claims, **characterized in that** the substrate or the carrier has any shape, for example curvatures.

12. Method according to any of the preceding claims, **characterized in that** the layer is structured during deposition or thereafter.

13. Method according to any of the preceding claims, **characterized in that** the layer is polarized during deposition or thereafter.

## Revendications

1. Procédé de fabrication d'une couche à propriétés piézoélectriques, les matières premières pulvérulentes étant déposées sur un substrat ou un support au moyen d'un flux de gaz par l'intermédiaire d'un procédé de séparation d'aérosols, et **caractérisé en ce que** les propriétés piézoélectriques de la couche sont formées à température ambiante ou par recuitP- à des températures jusqu'à 350 °C au plus, aucun traitement thermique de la poudre et/ou du substrat ou du support au moyen d'une source de chaleur externe à des températures supérieures à 350 °C n'ayant lieu pendant le revêtement.

2. Procédé selon la revendication 1, **caractérisé en ce que** la couche est constituée de PZT ou d'une matière contenant du PZT ou de céramique piézoélectrique sans plomb.

3. Procédé selon l'une des revendications précédentes, **caractérisé en ce que** le substrat ou le support est constitué de céramique, de plastique, de verre, de métal, de semiconducteur ou d'un composite des matières mentionnées.

4. Procédé selon la revendication 3, **caractérisé en ce que** le substrat ou le support présente une dureté inférieure à celle de la matière en vrac des matières premières pulvérulentes utilisées pour la séparation des aérosols.

5. Procédé selon l'une des revendications précédentes, **caractérisé en ce que** la force d'adhérence entre la couche et le substrat ou le support résulte entre autres d'une déformation plastique microstructurale de la surface du substrat ou du support (ancrage mécanique).

6. Procédé selon l'une des revendications précédentes, **caractérisé en ce que** la couche présente une épaisseur < 100 µm, présente une structure poreuse à dense et les granulométries de la couche sont inférieures à 1 µm.

7. Procédé selon l'une des revendications précédentes, **caractérisé en ce que** la couche recouvre totalement ou partiellement le substrat ou le support après le procédé de revêtement.

8. Procédé selon l'une des revendications précédentes, **caractérisé en ce que** le support est pourvu d'une couche intermédiaire sur laquelle la séparation a lieu totalement ou partiellement.

9. Procédé selon l'une des revendications précédentes, **caractérisé en ce que** des électrodes, lesquelles permettent le fonctionnement, sont disposées sur la surface totale ou partielle sous ou sur la couche.

10. Procédé selon la revendication 9, **caractérisé en ce que** des électrodes, lesquelles permettent le fonctionnement, sont disposées dans une structure interdigitée sous et/ou sur la couche.

11. Procédé selon l'une des revendications précédentes, **caractérisé en ce que** le substrat ou le support présente une forme quelconque, par exemple des courbures.

12. Procédé selon l'une des revendications précédentes, **caractérisé en ce que** la couche est structurée lors de la séparation ou après.

13. Procédé selon l'une des revendications précédentes, **caractérisé en ce que** la couche est polarisée lors de la séparation ou après.
